(19) Europäisches Patentamt
European Patent Office
Office européen des brevets

(11) **EP 2 438 206 B1**

(12) **EUROPÄISCHE PATENTSCHRIFT**

(45) Veröffentlichungstag und Bekanntmachung des Hinweises auf die Patenterteilung:
**25.06.2014 Patentblatt 2014/26**

(21) Anmeldenummer: **10721468.6**

(22) Anmeldetag: **13.05.2010**

(51) Int Cl.:
*C23C 16/46* *(2006.01)*       *C23C 16/24* *(2006.01)*
*C23C 16/26* *(2006.01)*       *C23C 16/27* *(2006.01)*
*C23C 16/28* *(2006.01)*

(86) Internationale Anmeldenummer:
**PCT/EP2010/056625**

(87) Internationale Veröffentlichungsnummer:
**WO 2010/139543 (09.12.2010 Gazette 2010/49)**

(54) **BESCHICHTUNGSANLAGE UND -VERFAHREN**

COATING INSTALLATION AND METHOD

INSTALLATION ET PROCÉDÉ DE REVÊTEMENT

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **02.06.2009 DE 102009023471**

(43) Veröffentlichungstag der Anmeldung:
**11.04.2012 Patentblatt 2012/15**

(73) Patentinhaber: **Fraunhofer Gesellschaft zur Förderung der angewandten Forschung e.V.
80686 München (DE)**

(72) Erfinder:
• **HARIG, Tino
38685 Langelsheim (DE)**
• **HÖFER, Markus
38162 Cremlingen-Gardessen (DE)**

• **LAUKART, Artur
38112 Braunschweig (DE)**
• **SCHÄFER, Lothar
38527 Meine (DE)**
• **ARMGARDT, Markus
38108 Braunschweig (DE)**

(56) Entgegenhaltungen:
**EP-A1- 1 258 914        JP-A- 2009 038 398
US-A1- 2008 095 937**

• **FRIGERI P A ET AL: "Hot wire chemical vapor deposition: limits and opportunities of protecting the tungsten catalyzer from silicide with a cavity" THIN SOLID FILMS, ELSEVIER-SEQUOIA S.A. LAUSANNE, CH LNKD- DOI:10.1016/J.TSF. 2009.01.023, Bd. 517, Nr. 12, 30. April 2009 (2009-04-30), Seiten 3427-3430, XP026052738 ISSN: 0040-6090 [gefunden am 2009-01-22]**

**Beschreibung**

Die Erfindung betrifft eine Beschichtungsanlage, enthaltend zumindest einen evakuierbaren Rezipienten, welcher zur Aufnahme eines Substrates vorgesehen ist, zumindest eine Gaszufuhreinrichtung, mittels welcher zumindest ein gasförmiger Prekursor in den Rezipienten einleitbar ist und zumindest ein beheizbares Aktivierungselement, welches eine vorgebbare Längsausdehnung aufweist und mittels zumindest einer zugeordneten mechanischen Befestigungsvorrichtung relativ zum Rezipienten nahezu unbeweglich befestigt ist. Weiterhin betrifft die Erfindung ein korrespondierendes Beschichtungsverfahren.

Beschichtungsanlagen der eingangs genannten Art sind gemäß dem Stand der Technik dazu vorgesehen, ein Substrat mittels einer heißdrahtaktivierten chemischen Gasphasenabscheidung zu beschichten. Die abgeschiedenen Schichten können beispielsweise Kohlenstoff, Silizium oder Germanium enthalten. Entsprechend können die gasförmigen Prekursoren beispielsweise Methan, Monosilan, Monogerman, Ammoniak oder Trimethylsilan enthalten.

Aus K. Honda, K. Ohdaira and H. Matsumura, Jpn. J. App. Phys., Vol. 47, No. 5 ist bekannt, eine Beschichtungsanlage der eingangs genannten Art zur Abscheidung von Silizium zu verwenden. Hierzu wird mittels der Gaszufuhreinrichtung Silan ($SiH_4$) als Prekursor zugeführt. Gemäß dem Stand der Technik wird der Prekursor an der beheizten Wolframoberfläche eines Aktivierungselementes dissoziiert und aktiviert, so dass eine Siliziumschicht oder eine siliziumhaltige Schicht auf einem Substrat abgeschieden werden kann.

Die US 2008/095937 A1 zeigt eine Vorrichtung zur heißdrahtaktivierten Gasphasenabscheidung dünner Schichten mit einer Vakuumkammer, einem Substrathalter, einer Halteeinrichtung für den Heißdraht, einer Gaszufuhreinrichtung und einer Vorrichtung, welche einen neuen Abschnitt des Heißdrahtes bereitstellen kann, ohne das Vakuum in der Vakuumkammer zu brechen.

Nachteilig am genannten Stand der Technik ist jedoch, dass insbesondere an den kälteren Einspannstellen des Aktivierungselementes eine unerwünschte Umsetzung des Materials des Aktivierungselementes mit dem Prekursor stattfindet. Beispielsweise kann die Verwendung einer Silan-Verbindung als Prekursor zur Bildung von Silizid-Phasen am Aktivierungselement führen.

Die bei der Umsetzung entstehenden Silizid-Phasen führen in der Regel zu Volumenveränderungen des Aktivierungselementes, sind im Vergleich zum Ausgangsmaterial spröde und mechanisch wenig belastbar und zeigen oftmals einen veränderten elektrischen Widerstand. Dies führt dazu, dass das Aktivierungselement oftmals bereits nach wenigen Stunden Betrieb zerstört ist. Beispielsweise kann das Aktivierungselement unter einer mechanischen Vorspannung im Rezipienten eingesetzt sein und unter dem Einfluss dieser mechanischen Vorspannung brechen. Um ein Brechen des Aktivierungselementes unter einer mechanischen Vorspannung zu verhindern, schlägt der Stand der Technik die Spülung der Einspannstellen mit einem Inertgas vor. Zwar zeigt der Stand der Technik im begrenzten Umfang eine Verlängerung der Lebensdauer, diese ist jedoch bei länger andauernden Beschichtungsverfahren oder zur Durchführung mehrerer kürzerer Beschichtungsverfahren unmittelbar hintereinander weiterhin unzureichend. Weiterhin beeinflusst das eingesetzte Inertgas das Beschichtungsverfahren.

Der Erfindung liegt somit die Aufgabe zugrunde, die Lebensdauer eines Aktivierungselementes in einer Beschichtungsanlage zur heißdrahtaktivierten chemischen Gasphasenabscheidung zu verlängern, ohne den Beschichtungsprozess nachteilig zu beeinflussen. Weiterhin besteht die Aufgabe der Erfindung darin, die Prozessstabilität zu erhöhen und/oder die Prozessregelung zu vereinfachen.

Die Aufgabe wird erfindungsgemäß durch eine Beschichtungsanlage gemäß Anspruch 1 sowie ein Beschichtungsverfahren gemäß Anspruch 8 gelöst.

Erfindungsgemäß wird vorgeschlagen, in an sich bekannter Weise ein zu beschichtendes Substrat in einem evakuierbaren Rezipienten einzubringen. Der Rezipient kann beispielsweise aus Aluminium, Edelstahl, Keramik und/oder Glas bestehen. Der Rezipient wird in an sich bekannter Weise, beispielsweise durch Dichtungselemente aus Metall oder Polymer bzw. durch Schweiß- und Lötverbindungen im Wesentlichen luftdicht abgeschlossen. Der Rezipient kann mittels einer Vakuumpumpe evakuiert werden.

Über eine Gaszufuhreinrichtung wird zumindest ein gasförmiger Prekursor mit vorgebbarem Partialdruck in den Rezipienten eingeleitet. Beispielsweise kann der Prekursor Methan, Silane, Germane, Ammoniak, Trimethylsilan, Sauerstoff und/oder Wasserstoff enthalten.

Zur Schichtabscheidung wird zumindest ein im Innenraum des Rezipienten angeordnetes Aktivierungselement beheizt. Insbesondere kann die Beheizung des Aktivierungselements durch eine Elektronenstoßheizung und/oder eine elektrische Widerstandsheizung erfolgen. Das Aktivierungselement enthält im Wesentlichen ein Refraktärmetall, wie beispielsweise Molybdän, Niob, Wolfram oder Tantal, oder eine Legierung aus diesen Metallen. Daneben kann das Aktivierungselement weitere chemische Elemente enthalten, welche entweder unvermeidbare Verunreinigungen darstellen oder als Legierungsbestandteil die Eigenschaften des Aktivierungselements an die gewünschten Eigenschaften anpassen. Das Aktivierungselement kann die Form eines Drahtes, einer Platte, eines Rohres, eines Zylinders und/oder weiterer, komplexerer Geometrien annehmen.

An der Oberfläche des Aktivierungselements werden die Moleküle des gasförmigen Prekursors zumindest teilweise dissoziiert oder angeregt. Die Anregung und/oder Dissoziation kann aufgrund von katalytischen Eigenschaften der Oberfläche des Aktivierungselements unterstützt werden. Die auf diese Weise aktivierten Moleküle gelangen an die Oberfläche des Substrats und bilden dort die gewünschte Beschichtung. Daneben können Moleküle des gasförmigen Prekursors zumindest teilweise mit dem Material des Aktivierungselements umgesetzt werden. In Abhängigkeit der Temperatur des Aktivierungselements kann die Anregung und/oder die Dissoziation und/oder die Umsetzung mit dem Material des Aktivierungselements unterdrückt oder beschleunigt sein.

Um dem Aktivierungselement einen elektrischen Strom zuzuführen, sind zumindest zwei Kontaktelemente vorgesehen, mittels welchen das Aktivierungselement mit einer elektrischen Strom- oder Spannungsquelle verbindbar ist. In einem Aktivierungselement mit homogener Materialzusammensetzung und konstantem Querschnitt wird die beim Durchfluss eines elektrischen Stromes deponierte thermische Energie gleichmäßig entlang der Längserstreckung eingebracht.

Aufgrund der vergrößerten Wärmeleitfähigkeit und/oder der vergrößerten Wärmeabstrahlung des Kontaktelements kann das Aktivierungselement in einem Abschnitt in der Nähe des Kontaktelements eine geringere Temperatur aufweisen, verglichen mit einem Abschnitt, welcher eine größere Entfernung zum Kontaktelement aufweist. In diesem Fall kann in einem Abschnitt in der Nähe des Kontaktelements die Temperatur des Aktivierungselements so weit absinken, dass das Material des Aktivierungselements mit dem Prekursor bevorzugt eine chemische Umsetzung erfährt. Beispielsweise kann ein wolframhaltiges Aktivierungselement mit einem siliziumhaltigen Prekursor eine Wolfram-Silizid-Phase bilden.

Zur Lösung dieses Problems wird erfindungsgemäß vorgeschlagen, das Aktivierungselement mittels zumindest eines beweglichen Kontaktelements an wechselnden Kontaktstellen zu kontaktieren. Auf diese Weise verlagern sich mit dem Kontaktelement auch diejenigen Stellen, an welchen das Aktivierungselement eine reduzierte Temperatur aufweist. Dadurch erfährt das Aktivierungselement nicht während der gesamten Dauer des Beschichtungsverfahrens am selben Ort eine unerwünschte Phasenumwandlung bzw. eine Beschleunigung einer solchen Phasenumwandlung. In einigen Ausführungsformen der Erfindung kann auch eine zunächst erfolgte unerwünschte Phasenumwandlung, beispielsweise die Bildung eines Karbids oder eines Silizids, wieder rückgängig gemacht werden, wenn der in unerwünschter Weise umgewandelte Flächenbereich bzw. Teilabschnitt des Aktivierungselements nachfolgend auf eine erhöhte Temperatur aufgeheizt wird. Auf diese Weise wird die Lebensdauer des Aktivierungselements wunschgemäß erhöht.

Die Ausbildung wechselnder Kontaktstellen erfolgt erfindungsgemäß durch eine Bewegung des Kontaktelementes, wohingegen das Aktivierungselement relativ zum umgebenden Rezipienten unbeweglich bleibt. Im Sinne der vorliegenden Beschreibung ist das Aktivierungselement auch dann unbeweglich, wenn es durch thermische Ausdehnung eine geringe Längenänderung erfährt. Eine Bewegung des Aktivierungselementes durch bewegliche Befestigungselemente findet jedoch erfindungsgemäß nicht statt.

In einigen Ausführungsformen der Erfindung kann ein länglich geformtes Aktivierungselement eine größere Länge aufweisen, als der zur Aktivierung des Prekursors eingesetzte Bereich. Durch Verschieben der Kontaktelemente wird ein jeweils wechselnder Teilabschnitt des Aktivierungselements beheizt. Dabei können die Kontaktelemente gleichsinnig verschoben werden, so dass der zwischen den Kontaktelementen angeordnete beheizte Teilabschnitt jeweils konstant bleibt. Auf diese Weise wird die elektrische Regelung des Aktivierungselements vereinfacht.

In einer Ausführungsform der Erfindung kann das Kontaktelement eine Mehrzahl von Kontaktstiften enthalten, welche entlang der Längserstreckung des Aktivierungselements angeordnet sind und gegen das Aktivierungselement bewegbar sind. Auf diese Weise muss das Kontaktelement nicht zwingend in Richtung der Längserstreckung des Aktivierungselements bewegt werden. Ausreichend ist es vielmehr, zumindest einen Kontaktstift aus der Mehrzahl von Kontaktstiften in einer Bewegungsrichtung, welche im Wesentlichen senkrecht zur Längserstreckung des Aktivierungselementes verläuft, gegen das Aktivierungselement zu bewegen oder von diesem abzuheben. Dadurch kann eine örtlich wechselnde Kontaktstelle auf dem Aktivierungselement in einfacher und zuverlässiger Weise realisiert werden.

In einigen Ausführungsformen der Erfindung kann das Aktivierungselement zumindest einen Draht enthalten. Ein Draht im Sinne der vorliegenden Erfindung kann einen runden, einen ovalen oder einen polygonalen Querschnitt aufweisen. Auf diese Weise kann das Verhältnis von Oberfläche zu Volumen des Aktivierungselements vergrößert werden. Ein solches Aktivierungselement kann in einigen Ausführungsformen der Erfindung über zumindest eine Rolle geführt bzw. umgelenkt werden. Die Rolle kann Teil eines Kontaktelements sein, welches das Aktivierungselement zugleich elektrisch mit einer Strom- oder Spannungsquelle kontaktiert.

Nachfolgend soll die Erfindung anhand von Ausführungsbeispielen und Figuren ohne Beschränkung des allgemeinen Erfindungsgedankens näher erläutert werden. Dabei zeigt

Figur 1 den prinzipiellen Aufbau einer erfindungsgemäßen Beschichtungsanlage.

Figur 2 illustriert ein Ausführungsbeispiel des erfindungsgemäß vorgeschlagenen Aktivierungselements.

Figur 3 zeigt ein weiteres Ausführungsbeispiel eines erfindungsgemäß vorgeschlagenen Aktivierungselements.

Figur 4 zeigt zwei Kontaktelemente, welche jeweils eine Mehrzahl von Kontaktstiften enthalten.

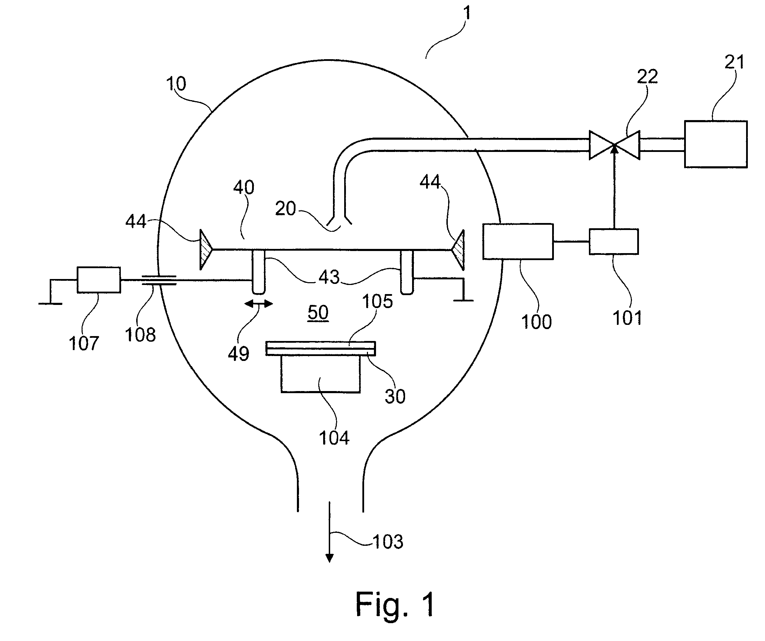

Figur 1 zeigt einen Querschnitt durch eine Beschichtungsanlage 1. Die Beschichtungsanlage 1 umfasst einen Rezipienten 10, welcher beispielsweise aus Edelstahl, Aluminium, Glas oder einer Kombination dieser Materialien hergestellt ist. Der Rezipient 10 ist gegenüber der Umgebung im Wesentlichen luftdicht abgeschlossen. Über einen Pumpenflansch 103 kann eine nicht dargestellte Vakuumpumpe angeschlossen werden. Beispielsweise kann der Rezipient 10 auf einen Druck von weniger als $10^0$ mbar, weniger als $10^{-2}$ mbar oder weniger als $10^{-6}$ mbar evakuiert werden.

Innerhalb des Rezipienten 10 befindet sich eine Haltevorrichtung 104, auf welcher ein Substrat 30 gehaltert werden kann. Das Substrat 30 kann beispielsweise aus Glas, Silizium, Kunststoff, Keramik, Metall oder einer Legierung bestehen. Das Substrat kann ein Halbleiterwafer, eine Scheibe oder ein Werkzeug sein. Es kann eine ebene oder gekrümmte Oberfläche aufweisen. Die genannten Materialien sind dabei nur beispielhaft genannt. Die Erfindung lehrt nicht die Verwendung eines bestimmten Substrates als Lösungsprinzip. Bei Betrieb der Beschichtungsanlage 1 wird auf dem Substrat 30 eine Beschichtung 105 abgeschieden.

Die Zusammensetzung der Beschichtung 105 wird durch die Wahl des gasförmigen Prekursors beeinflusst. In einer Ausführungsform der Erfindung kann der Prekursor Methan enthalten, so dass die Beschichtung 105 Diamant oder diamantartigen Kohlenstoff enthält. In einer anderen Ausführungsform der Erfindung kann der Prekursor Monosilan und/oder Monogerman enthalten, so dass die Beschichtung kristallines oder amorphes Silizium und/oder Germanium enthält.

Der gasförmige Prekursor wird über mindestens eine Gaszufuhreinrichtung 20 in das Innere des Rezipienten 10 eingebracht. Die Gaszufuhreinrichtung 20 bezieht den gasförmigen Prekursor aus einem Vorratsbehälter 21. Die Menge des aus dem Vorratsbehälter 21 entnommenen Prekursors kann über ein Regelventil 22 beeinflusst werden. Sofern die Beschichtung 105 aus mehreren unterschiedlichen Prekursoren zusammengesetzt ist, kann der Vorratsbehälter 21 eine vorbereitete Gasmischung enthalten oder aber es können mehrere Gaszufuhreinrichtungen 20 vorgesehen sein, welche jeweils eine Komponente des zusammengesetzten Prekursors in den Rezipienten 10 einleiten.

Die über das Regelventil 22 der Gaszufuhreinrichtung 20 zugeführte Menge des Prekursors wird über eine Regeleinrichtung 101 kontrolliert. Der Regeleinrichtung 101 wird ein IstWert eines Partial- oder Absolutdrucks durch eine Messeinrichtung 100 zugeführt.

Zur Aktivierung des gasförmigen Prekursors steht eine Aktivierungseinrichtung 40 zur Verfügung. Das Aktivierungselement 40 enthält eine oder mehrere katalytisch wirksame Flächen, beispielsweise in Form eines Bleches oder eines Drahtes. Beispielsweise kann das Aktivierungselement 40 Wolfram, Molybdän, Niob und/oder Tantal enthalten.

Das Aktivierungselement 40 ist an zumindest einem Halteelement 44 befestigt. Das Halteelement 44 fixiert das Aktivierungselement 40 an einer vorgebbaren Position und/oder mit einer vorgebbaren mechanischen Spannung. Zumindest ein Halteelement 44 kann elektrisch isoliert ausgeführt werden, um das Aktivierungselement zumindest teilweise auf ein vorgebbares elektrisches Potential zu bringen.

Bei Betrieb des Aktivierungselementes bildet sich innerhalb des Rezipienten 10 eine Wirkzone 50 aus, in welcher dissoziierte und/oder angeregte Bestandteile des Prekursors nachweisbar sind. Die Aktivität der Oberfläche des Aktivierungselementes 40 wird bei einer gegenüber der Raumtemperatur erhöhten Temperatur erreicht. Zur Erwärmung des Aktivierungselementes 40 ist gemäß Figur 1 vorgesehen, zumindest zwei elektrische Kontaktelemente 43 vorzusehen. Mittels der Kontaktelemente 43 kann zumindest ein Ende des Aktivierungselementes mittels einer vakuumdichten Durchführung 108 mit einer Stromquelle 107 verbunden werden. In diesem Fall erfolgt die Erwärmung des Aktivierungselementes 40 durch Widerstandsheizung. Sofern das Aktivierungselement aus einem homogenen Material besteht und eine gleichmäßige Dicke aufweist, ist die entlang der Längserstreckung x des Aktivierungselementes eingebrachte Heizleistung E konstant: $\dfrac{\partial E}{\partial x} = const.$

Aufgrund der Wärmeleitung und/oder Wärmestrahlung der Halteelemente 44 und/oder der Kontaktelemente 43 nimmt die Temperatur des Aktivierungselementes 40 ausgehend von der geometrischen Mitte zum Rand hin ab, wenn die Heizleistung über die Länge des Drahtes im Wesentlichen konstant ist. Dabei kann sich in der Nähe des Kontaktelements 43 eine Temperatur einstellen, bei welcher das Material des Aktivierungselementes 40 mit dem gasförmigen Prekursor beschleunigt zu unerwünschten Phasen umgesetzt wird, beispielsweise Karbiden und/oder Siliziden und/oder Germaniden.

Um den schädigenden Einfluss des Prekursors auf das Aktivierungselement zu minimieren, wird gemäß Figur 1 vorgeschlagen, ein Aktivierungselement 40 einzusetzen, dessen geometrische Abmessungen größer sind als die Abmessungen der Wirkzone 50. Das Aktivierungselement 40 wird mittels der Halteelemente 44 elektrisch isoliert innerhalb des Rezipienten 10 gelagert. Die zwei Kontaktelemente 43, stehen beispielsweise über Rollen, Walzen, Schleifkontakte oder ähnliche Elemente mit dem Aktivierungselement 40 in Kontakt.

Die Kontaktelemente 43 sind entlang einer Transportrichtung 49, welche entlang der Längserstreckung des Aktivierungselements 40 verläuft, beweglich. In der in Figur 1 dargestellten Ausführungsform werden beide Kontaktelemente 43 entlang des Aktivierungselements 40 bewegt. Dabei kann die Bewegung gleichsinnig erfolgen, so dass der zwischen den Kontaktelementen 43 eingeschlossene Abschnitt des Aktivierungselements 40 in etwa konstant bleibt, oder aber die Bewegung erfolgt gegensinnig oder unkorreliert, so dass der von den Kontaktelementen 43 eingeschlossene Abschnitt seitlich variabel ist. Die Bewegung der Kontaktelemente 43 entlang der Transportrichtung 49 kann harmonisch oder anharmonisch, sowie kontinuierlich oder mit dazwischen liegenden Pausen erfolgen.

Die Bewegung der Kontaktelemente 43 hat die Wirkung, dass der Ort niedrigerer Temperatur, welcher sich in der Nähe der Kontaktstelle des Kontaktelements 43 auf dem Aktivierungselement 40 ausbildet, örtlich variabel ist. Auf diese Weise wird der schädigende Einfluss des Prekursors auf das Aktivierungselement 40 auf einen größeren Flächenbereich des Aktivierungselements verteilt, so dass die Lebensdauer des Aktivierungselements insgesamt vergrößert wird. In einigen Ausführungsformen der Erfindung kann darüber hinaus vorgesehen sein, dass sich ein unter Anwesenheit des Prekursors bei niedrigen Temperaturen geschädigter Bereich durch Erhöhen der Temperatur beim Wegbewegen des Kontaktelements 43 wieder regeneriert, indem die unerwünschten Phasen des Aktivierungselements 40 eine erneute Umsetzung erfahren.

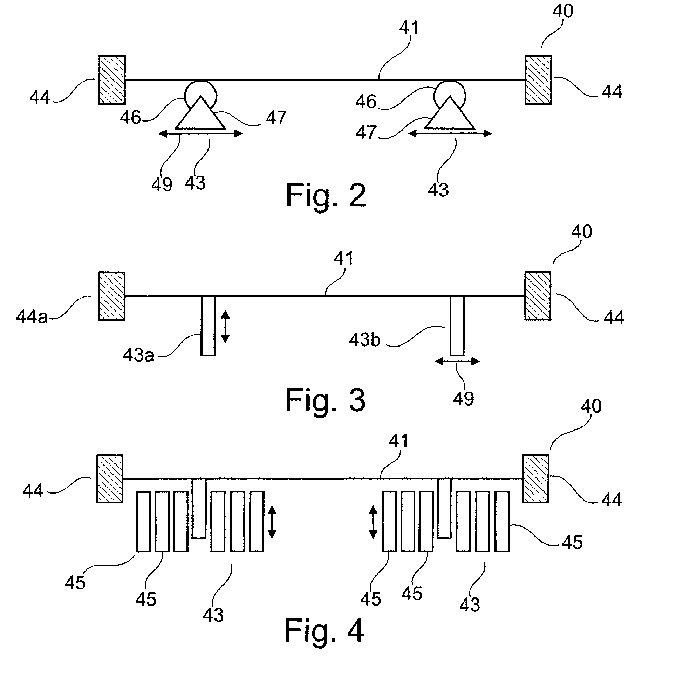

Figur 2 zeigt ein Ausführungsbeispiel eines Aktivierungselements 40 in einer weiter detaillierten Darstellung. Die aktive Oberfläche des Aktivierungselements 40 wird in dieser Ausführungsform der Erfindung durch einen Draht 41 gebildet, welcher beispielsweise Wolfram, Niob, Molybdän oder Tantal enthält. Figur 2 zeigt weiterhin zwei Halteelemente 44, zwischen welchen das Aktivierungselement 40 fixiert ist. Die Halteelementen 44 können das Aktivierungselement 40 isoliert aufnehmen. Die Befestigung des Aktivierungselements an den Halteelementen 44 kann beispielsweise durch Klemmung, Schweißen oder durch eine Feder erfolgen. Auf diese Weise kann die mechanische Spannung im Aktivierungselement 40 konstant gehalten werden.

Zur Kontaktierung des Drahtes 41 stehen zwei Kontaktelemente 43 zur Verfügung, welche auf unterschiedlichem elektrischem Potential gehalten werden. Durch das unterschiedliche Potential fließt zwischen den Kontaktelementen 43 durch den Draht 41 ein elektrischer Strom, welcher zur Beheizung des Drahtes 41 dienen kann. Der elektrische Kontakt zwischen dem Draht 41 und dem Kontaktelement 43 wird durch eine Rolle 46 vermittelt. Die Rolle 46 ist drehbar in einem Rollenträger 47 gehaltert. Die Rolle 46 kann eine Nut entlang ihrer Umfangsfläche aufweisen, welche den Draht 41 aufnehmen kann und einen zuverlässigen elektrischen Kontakt sicherstellt, ohne dass der Draht 41 von der Rolle 46 abläuft. Für die Rolle 46 kann ein Material verwendet werden, welches eine gute elektrische Leitfähigkeit mit einer schlechten thermischen Leitfähigkeit verbindet, beispielsweise Edelstahl.

Der Rollenträger 47 wird entlang einer Transportrichtung 49 bewegt, welche im Wesentlichen parallel zum Draht 41 verläuft. Hierzu kann der Rollenträger 47 beispielsweise mittels einer Schiene, einer Säulenführung, einer Zahnstange oder einer Gewindestange geführt werden. Die Bewegung des Rollenträgers 47 kann in wechselnden Richtungen erfolgen oder unidirektional von einem Ende des Aktivierungselements 40 zum anderen Ende.

Ein weiteres Ausführungsbeispiel eines Aktivierungselements 40 ist in Figur 3 dargestellt. Figur 3 zeigt wiederum einen Draht 41, welcher mittels zweier Halteelemente 44 mechanisch fixiert wird. Am Draht 41 liegen zwei Kontaktelemente 43 an, welche beispielsweise einen Schleifkontakt aufweisen. Der Schleifkontakt kann beispielsweise durch Federkraft gegen den Draht 41 geführt werden, um eine konstante Andruckkraft sicher zu stellen.

Gemäß Figur 3 wird ein Kontaktelement 43b entlang der Bewegungsrichtung 49 parallel zum Draht 41 geführt. Auf diese Weise kann die Kontaktstelle entlang des Drahtes 41 verschoben werden, so dass der Teilabschnitt mit der niedrigsten Temperatur entlang des Drahtes 41 variiert.

Das in Figur 3 links dargestellte Kontaktelement 43a wird in eine Richtung bewegt, welche in etwa senkrecht zur Längserstreckung des Drahtes 41 verläuft. Auf diese Weise kann das Kontaktelement 43 den Draht 41 entweder berühren oder nicht. Sofern das Kontaktelement 43 vom Draht 41 abgehoben ist, wird der Stromkreis über das elektrisch leitfähige Halteelement 44a abgeführt. Auf diese Weise kann die Kontaktstelle am Draht 41 diskret geändert werden, nämlich entweder am Endpunkt des Halteelementes 44a oder am Abgriff des Kontaktelementes 43a.

Figur 4 zeigt zwei Kontaktelemente 43, welche jeweils eine Mehrzahl von Kontaktstiften 45 enthalten. Die Kontaktstifte 45 sind entlang der Längserstreckung des Aktivierungselements 40 bzw. des Drahtes 41 angeordnet. Die Kontaktstifte 45 sind entlang einer Bewegungsrichtung verschiebbar gelagert, welche in etwa orthogonal zur Längserstreckung des Drahtes 41 verläuft. Entlang dieser Bewegungsrichtung können die Kontaktstifte 45 beispielsweise durch Federkraft gegen den Draht 41 geführt werden. Durch Bewegen zumindest eines Kontaktstiftes kann der Ort der Kontaktierung auf dem Draht 41 in diskreten Stufen variiert werden. Nicht benötigte Kontaktstifte 45 können vom Draht 41 abgehoben werden, so dass diese keine Wärmebrücke darstellen. Auf diese Weise kann die Temperatur des Drahtes 41 so kontrolliert werden, dass sich nicht an einer Stelle unerwünschte, schädigende Phasen in kurzer Zeit bilden.

Selbstverständlich können die in den Figuren 2 bis 4 dargestellten Merkmale auch kombiniert werden, um auf diese Weise weitere Ausführungsformen des erfindungsgemäßen Aktivierungselements zu erhalten. Daher ist die vorstehende Beschreibung nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche "erste" und "zweite" Merkmale definieren, so dient diese Bezeichnung der Unterscheidung zweier gleichartiger Merkmale, ohne eine Rangfolge festzulegen.

**Patentansprüche**

1. Beschichtungsanlage (1), enthaltend zumindest einen evakuierbaren Rezipienten (10), welcher zur Aufnahme eines Substrates (30) vorgesehen ist, zumindest eine Gaszufuhreinrichtung (20, 21, 22), mittels welcher zumindest ein gasförmiger Prekursor in den Rezipienten (10) einleitbar ist und zumindest ein beheizbares Aktivierungselement (40), welches eine vorgebbare Längsausdehnung aufweist und welches mittels zumindest einer zugeordneten mechanischen Befestigungsvorrichtung (44) relativ zum Rezipienten (10) befestigt ist und welchem über zumindest zwei Kontaktelemente (43) ein elektrischer Strom zuführbar ist, **dadurch gekennzeichnet, dass** zumindest eines der Kontaktelemente (43) dazu eingerichtet ist, das Aktivierungselement (40) an wechselnden Kontaktstellen zu kontaktieren, und dass das befestigte Aktivierungselement (40) nahezu unbeweglich befestigt ist.

2. Beschichtungsanlage (1) nach Anspruch 1, **dadurch gekennzeichnet, dass** das Kontaktelement (43) eine Mehrzahl von Kontaktstiften (45) enthält, welche entlang der Längserstreckung des Aktivierungselements (40) angeordnet sind und gegen das Aktivierungselement (40) bewegbar sind.

3. Beschichtungsanlage (1) nach Anspruch 1 oder 2, **dadurch gekennzeichnet, dass** das Aktivierungselement (40) zumindest einen Draht (41) enthält.

4. Beschichtungsanlage (1) nach einem der Ansprüche 1 bis 3, **dadurch gekennzeichnet, dass** das Kontaktelement (43) zumindest eine Rolle (46) enthält, welche dazu vorgesehen ist, mit dem Aktivierungselement (40) in Kontakt zu stehen.

5. Beschichtungsanlage (1) nach einem der Ansprüche 3 oder 4, **dadurch gekennzeichnet, dass** der Draht (41) mehrfach durch die Wirkzone (50) geführt ist.

6. Beschichtungsanlage (1) nach einem der Ansprüche 1 bis 5, **dadurch gekennzeichnet, dass** eine Mehrzahl von Kontaktelementen (43) entlang der Längserstreckung des Aktivierungselements (40) angeordnet sind, welche jeweils mit einer vorgebbaren elektrischen Potentialdifferenz beaufschlagbar sind.

7. Beschichtungsanlage (1) nach einem der Ansprüche 1 bis 6, **dadurch gekennzeichnet, dass** die mechanische Befestigungsvorrichtung (44) elektrisch isoliert ist.

8. Verfahren zur Herstellung einer Beschichtung (105) eines Substrates (30), bei welchem das Substrat in einen evakuierbaren Rezipienten (10) eingebracht wird, über zumindest eine Gaszufuhreinrichtung (20, 21, 22) zumindest ein gasförmiger Prekursor in den Rezipienten (10) eingeleitet und mittels zumindest einem elektrisch beheizten Aktivierungselementes (40) aktiviert wird, wobei dem Aktivierungselement (40) mittels zumindest zweier Kontaktelemente (43) ein elektrischer Strom zugeführt wird, wobei zwischen zumindest einem der Kontaktelemente (43) und dem Aktivierungselement (40) eine relative Bewegung erfolgt, **dadurch gekennzeichnet, dass** das Aktivierungselement (40) näherungsweise ortsfest im Rezipienten angeordnet ist..

9. Verfahren nach Anspruch 8, **dadurch gekennzeichnet, dass** die Bewegung oszillierend erfolgt.

10. Verfahren nach Anspruch 8 oder 9, bei welchem das Kontaktelement (43) eine Mehrzahl von Kontaktstiften (45) enthält, welche entlang der Längserstreckung des Aktivierungselements (40) angeordnet sind und wechselweise gegen das Aktivierungselement (40) bewegt werden.

11. Verfahren nach einem der Ansprüche 8 bis 10, bei welchem das Aktivierungselement (40) zumindest einen Draht (41) enthält.

12. Verfahren nach Anspruch 11, bei welchem der Draht (41) die Wirkzone (50) mehrfach passiert.

13. Verfahren nach einem der Ansprüche 8 bis 12, bei welchem eine Mehrzahl von Kontaktelementen (43) entlang der Längserstreckung des Aktivierungselements (40) mit diesem in Kontakt steht und jedes Kontaktelement (43) mit einer vorgebbaren elektrischen Potentialdifferenz beaufschlagt wird.

**Claims**

1. Coating system (1), containing at least one recipient (10) which can be evacuated and is provided for receiving a substrate (30), at least one gas supply apparatus (20, 21, 22), by means of which at least one gaseous precursor can be introduced into the recipient (10), and at least one heatable activation element (40) which has a settable longitudinal extension and which is attached relative to the recipient (10) by means of at least one assigned mechanical attachment device (44) and to which an electric current can be supplied via at least two contact elements (43), **characterized in that** at least one of the contact elements (43) is adapted to contact the activation element (40) at changing contact points and that the attached activation element (40) is fixed in almost immovable fashion.

2. Coating system (1) according to claim 1, **characterized in that** the contact element (43) contains a plurality of contact pins (45) which are arranged along the longitudinal extension of the activation element (40) and are movable against the activation element (40).

3. Coating system (1) according to claim 1 or 2, **characterized in that** the activation element (40) contains at least one wire (41).

4. Coating system (1) according to any of claims 1 to 3, **characterized in that** the contact element (43) contains at least one roller (46) which is adapted to be in contact with the activation element (40).

5. Coating system (1) according to claim 3 or 4, **characterized in that** the wire (41) is guided multiple times through the active zone (50).

6. Coating system (1) according to any of claims 1 to 5, **characterized in that** a plurality of contact elements (43) is arranged along the longitudinal extension of the activation element (40), to each of which a settable electric potential difference can be applied.

7. Coating system (1) according to any of claims 1 to 6, **characterized in that** the mechanical attachment device (44) is electrically insulated.

8. Method for producing a coating (105) of a substrate (30), wherein the substrate is introduced into a recipient (10) that can be evacuated, at least one gaseous precursor is introduced into the recipient (10) via at least one gas supply apparatus (20, 21, 22) and is activated by means of at least one electrically heatable activation element (40), wherein the activation element (40) is supplied with an electric current by means of at least two contact elements (43), wherein there is a relative movement between at least one of the contact elements (43) and the activation element (40), **characterized in that** the activation element (40) is arranged in the recipient in approximately stationary fashion.

9. Method according to claim 8, **characterized in that** the movement is made in oscillating fashion.

10. Method according to claim 8 or 9, wherein the contact element (43) contains a plurality of contact pins (45) which are arranged along the longitudinal extension of the activation element (40) and are alternately moved against the activation element (40).

11. Method according to any of claims 8 to 10, wherein the activation element (40) contains at least one wire (41).

12. Method according to claim 11, wherein the wire (41) passes through the active zone (50) multiple times.

13. Method according to any of claims 8 to 12, wherein a plurality of contact elements (43) along the longitudinal extension of the activation element (40) is in contact with the latter and a settable electric potential difference is applied to each contact element (43).

**Revendications**

1. Installation de revêtement (1), contenant au moins un récipient (10) susceptible d'être évacué, qui est prévu pour recevoir un substrat (30), au moins un système d'amenée de gaz (20, 21, 22) au moyen duquel au moins un précurseur sous forme gazeuse peut être introduit dans le récipient (10), et au moins un élément d'activation (40) capable d'être chauffé, qui présente une extension longitudinale prédéterminée et qui est fixé par rapport au récipient (10) au moyen d'au moins un dispositif de fixation mécanique associé (44) et auquel peut être amené un courant électrique via au moins trois éléments de contact (43), **caractérisée en ce que** l'un au moins des éléments de contact (43) est conçu pour venir en contact avec l'élément d'activation (40) à des emplacements de contact changeants, et **en ce que** l'élément d'activation (40) fixé est fixé pratiquement de manière indéplaçable.

2. Installation de revêtement (1) selon la revendication 1, **caractérisée en ce que** l'élément de contact (43) contient une pluralité de pointes de contact (45) qui sont agencées le long de l'extension longitudinale de l'élément d'activation (40) et qui sont déplaçables par rapport à l'élément d'activation (40).

3. Installation de revêtement (1) selon la revendication 1 ou 2, **caractérisée en ce que** l'élément d'activation (40) contient au moins un fil (41).

4. Installation de revêtement (1) selon l'une des revendications 1 à 3, **caractérisée en ce que** l'élément de contact (43) contient au moins un galet (46), lequel est prévu pour être en contact avec l'élément d'activation (40).

**5.** Installation de revêtement (1) selon l'une des revendications 3 ou 4, **caractérisée en ce que** le fil (41) est mené plusieurs fois à travers la zone d'action (50).

**6.** Installation de revêtement (1) selon l'une des revendications 1 à 5, **caractérisée en ce qu'**une pluralité d'éléments de contact (43) sont agencés le long de l'extension longitudinale de l'élément d'activation (40), lesquels sont susceptibles d'être respectivement soumis à une différence de potentiel électrique prédéterminée.

**7.** Installation de revêtement (1) selon l'une des revendications 1 à 6, **caractérisée en ce que** le dispositif de fixation mécanique (44) est électriquement isolé.

**8.** Procédé pour la réalisation d'un revêtement (105) d'un substrat (30), dans lequel le substrat est introduit dans un récipient (10) susceptible d'être évacué, au moins un précurseur sous forme gazeuse est introduit dans le récipient (10) via au moins un système d'amenée de gaz (20, 21, 22), et est activé au moyen d'au moins un élément d'activation (40) chauffé par voie électrique, dans lequel on applique à l'élément d'activation (40) un courant électrique au moyen d'au moins deux éléments de contact (43), et dans lequel un déplacement relatif se produit entre l'un au moins des éléments de contact (43) et l'élément d'activation (40), **caractérisé en ce que** l'élément d'activation (40) est agencé approximativement de manière stationnaire dans le récipient.

**9.** Procédé selon la revendication 8, **caractérisé en ce que** le mouvement a lieu de façon oscillante.

**10.** Procédé selon la revendication 8 ou 9, dans lequel l'élément de contact (43) contient une pluralité de pointes de contact (45), qui sont agencées le long de l'extension longitudinale de l'élément d'activation (40) et qui sont déplacées de manière changeante par rapport à l'élément d'activation (40).

**11.** Procédé selon l'une des revendications 8 à 10, dans lequel l'élément d'activation (40) contient au moins un fil (41).

**12.** Procédé selon la revendication 11, dans lequel le fil (41) passe plusieurs fois à travers la zone d'action (50).

**13.** Procédé selon l'une des revendications 8 à 12, dans lequel une pluralité d'éléments de contact (43) sont en contact avec l'élément d'activation (40) le long de l'extension longitudinale de celui-ci, et chaque élément de contact (43) est soumis à une différence de potentiel électrique prédéterminée.

Fig. 1

# Fig. 2

# Fig. 3

# Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2008095937 A1

**In der Beschreibung aufgeführte Nicht-Patentliteratur**

- **K. HONDA ; K. OHDAIRA ; H. MATSUMURA.** *Jpn. J. App. Phys.,* vol. 47 (5